# EUROPEAN PATENT APPLICATION

(11) **EP 3 185 283 A1**
(43) Date of publication of application: **28.06.2017**
(21) Application number: 15833937.4
(22) Date of filing: 18.08.2015
(51) Int. Cl.: H01L 21/677, B82B 1/00, C01B 32/05, H01L 21/683

(54) **SEMICONDUCTOR TRANSPORT MEMBER AND SEMICONDUCTOR CARRYING MEMBER**

(30) Priority: 21.08.2014 JP 2014168243; 07.08.2015 JP 2015156711
(71) Applicant: Nitto Denko Corporation, Ibaraki-shi, Osaka 567-8680 (JP)
(72) Inventor: MAENO, Youhei, Ibaraki-shi Osaka 567-8680 (JP)
(74) Representative: Müller-Boré & Partner Patentanwälte PartG mbB
(86) International application number: PCT/JP2015/073129
(87) International publication number: WO 2016/027803

(57) **Abstract**

Provided is a semiconductor transport member that includes a semiconductor mounting member capable of expressing a strong gripping force and unlikely to cause a contaminant to adhere and remain on a semiconductor side. Also provided is a semiconductor mounting member capable of expressing a strong gripping force and unlikely to cause a contaminant to adhere and remain on a semiconductor side. The semiconductor transport member of the present invention includes: a carrying base; and a semiconductor mounting member, in which: the semiconductor mounting member includes a fibrous columnar structure; the fibrous columnar structure includes a fibrous columnar structure including a plurality of fibrous columnar objects; the fibrous columnar objects are each aligned in a direction substantially perpendicular to the carrying base; and a surface of the fibrous columnar structure on an opposite side to the carrying base has a coefficient of static friction against a glass surface of 2.0 or more.

## Description

### Technical Field

The present invention relates to a semiconductor transport member and a semiconductor mounting member.

### Background Art

In transporting a semiconductor (e.g., silicon wafer) the semiconductor is transported using a carrying member, for example, a movable arm or a movable table (see, for example, Patent Literatures 1 and 2). In such transport, a member on which the semiconductor is to be mounted (semiconductor mounting member) is required to have such a strong gripping force as to prevent the semiconductor from shifting in position on the carrying member while being transported.

However, a related-art semiconductor mounting member having a strong gripping force has a problem in that when the semiconductor is peeled from the semiconductor mounting member after its transport, a contaminant is liable to adhere and remain on a semiconductor side.

Meanwhile, when ceramics or the like, i.e., a material that is unlikely to cause a contaminant to adhere and remain on the semiconductor side is used as the semiconductor mounting member, there is a problem in that the gripping force is reduced and hence the semiconductor shifts in position on the semiconductor mounting member while being transported.

### Citation List

### Patent Literature

[PTL 1] JP 2001-351961 A
[PTL 2] JP 2013-138152 A

### Summary of Invention

### Technical Problem

It is an object of the present invention to provide a semiconductor transport member that includes a semiconductor mounting member capable of expressing a strong gripping force and unlikely to cause a contaminant to adhere and remain on a semiconductor side. It is another object of the present invention to provide a semiconductor mounting member capable of expressing a strong gripping force and unlikely to cause a contaminant to adhere and remain on a semiconductor side.

### Solution to Problem

A semiconductor transport member according to one embodiment of the present invention includes:
a carrying base; and
a semiconductor mounting member,
in which:
the semiconductor mounting member includes a fibrous columnar structure;
the fibrous columnar structure includes a fibrous columnar structure including a plurality of fibrous columnar objects;
the fibrous columnar objects are each aligned in a direction substantially perpendicular to the carrying base; and
a surface of the fibrous columnar structure on an opposite side to the carrying base has a coefficient of static friction against a glass surface of 2.0 or more.

In one embodiment, the semiconductor transport member further includes a binder between the a carrying base and the semiconductor mounting member.

In one embodiment, the fibrous columnar structure includes a carbon nanotube aggregate including a plurality of carbon nanotubes.

In one embodiment, the carbon nanotubes each have a plurality of walls, a distribution width of a wall number distribution of the carbon nanotubes is 10 walls or more, and a relative frequency of a mode of the wall number distribution is 25% or less.

In one embodiment, the carbon nanotubes each have a length of 300 µm or more.

In one embodiment, the carbon nanotubes each have a plurality of walls, a mode of a wall number distribution of the carbon nanotubes is present at 10 or less walls in number, and a relative frequency of the mode is 30% or more.

In one embodiment, the carbon nanotubes each have a length of 500 µm or more.

A semiconductor mounting member according to one embodiment of the present invention is a semiconductor mounting member to be used for carrying a semiconductor, including a fibrous columnar structure including a plurality of fibrous columnar objects,
in which a surface of the fibrous columnar structure has a coefficient of static friction against a glass surface of 2.0 or more.

In one embodiment, the fibrous columnar structure includes a carbon nanotube aggregate including a plurality of carbon nanotubes.

In one embodiment, the carbon nanotubes each have a plurality of walls, a distribution width of a wall number distribution of the carbon nanotubes is 10 walls or more, and a relative frequency of a mode of the wall number distribution is 25% or less.

In one embodiment, the carbon nanotubes each have a length of 300 µm or more.

In one embodiment, the carbon nanotubes each have a plurality of walls, a mode of a wall number distribution of the carbon nanotubes is present at 10 or less walls in number, and a relative frequency of the mode is 30% or more.

In one embodiment, the carbon nanotubes each have a length of 500 µm or more.

### Advantageous Effects of Invention

According to the present invention, the semiconductor transport member that includes a semiconductor mounting member capable of expressing a strong gripping force and unlikely to cause a contaminant to adhere and remain on a semiconductor side can be provided. According to the present invention, the semiconductor mounting member capable of expressing a strong gripping force and unlikely to cause a contaminant to adhere and remain on a semiconductor side can also be provided.

### Brief Description of Drawings

FIG. **1** is a schematic sectional view of an example of a semiconductor transport member according to a preferred embodiment of the present invention.
FIG. **2** is a schematic sectional view of an example of a semiconductor mounting member according to a preferred embodiment of the present invention.
FIG. **3** is a schematic sectional view of an apparatus for producing a carbon nanotube aggregate according to a preferred embodiment of the present invention.

### Description of Embodiments

A semiconductor transport member of the present invention includes a carrying base (carrying member) and a semiconductor mounting member.

Any appropriate carrying base to be used for a semiconductor transport member may be adopted as the carrying base included in the semiconductor transport member of the present invention. Examples of such carrying base include a transport arm, a transport table, a transport ring, a transport guide rail, a storage cassette, a hook, and a transport frame. The size and shape of such carrying base may be appropriately selected depending on purposes.

The semiconductor mounting member included in the semiconductor transport member of the present invention is a member on which a semiconductor is tobemounted. The semiconductormounting member included in the semiconductor transport member of the present invention includes a fibrous columnar structure.

The semiconductor mounting member included in the semiconductor transport member of the present invention may include any appropriate other member as long as the semiconductor mounting member includes the fibrous columnar structure to the extent that the effect of the present invention is not impaired. In order to sufficiently express the effect of the present invention, the semiconductor mounting member included in the semiconductor transport member of the present invention preferably consists of the fibrous columnar structure.

The fibrous columnar structure is a fibrous columnar structure including a plurality of fibrous columnar objects.

The length of each of the fibrous columnar objects is preferably from 100 µm to 3,000 µm, more preferably from 200 µm to 2,000 µm, still more preferably from 300 µm to 1,500 µm, particularly preferably from 400 µm to 1,000 µm, most preferably from 500 µm to 1,000 µm. When the length of each of the fibrous columnar objects falls within the above-mentioned range, there can be provided a semiconductor transport member that includes a semiconductor mounting member capable of expressing a stronger gripping force and more unlikely to cause a contaminant to adhere and remain on a semiconductor side.

The semiconductor transport member of the present invention may include a binder between the carrying base and the semiconductor mounting member. Any appropriate binder may be adopted as such binder as long as the binder has such an effect that the carrying base and the semiconductor mounting member can be bonded to each other. Examples of such binder include carbon paste, alumina paste, silver paste, nickel paste, gold paste, aluminum paste, titanium oxide paste, iron oxide paste, and chromium paste. When such binder is included, there can be provided a semiconductor transport member in which the carrying base and the semiconductor mounting member are sufficiently bonded to each other, and which includes a semiconductor mounting member capable of expressing a stronger gripping force and more unlikely to cause a contaminant to adhere and remain on a semiconductor side.

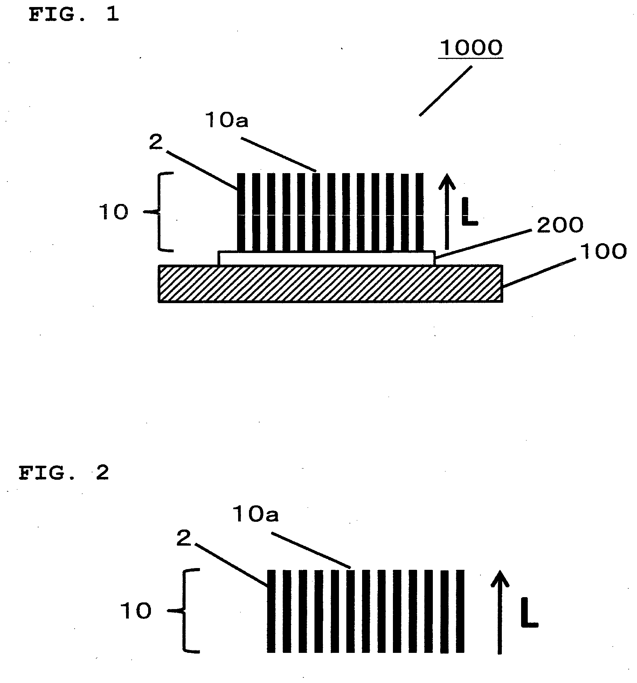

In FIG. **1****,** a schematic sectional view of an example of a semiconductor transport member according to a preferred embodiment of the present invention is illustrated.

InFIG. **1,** a semiconductor transport member **1000** includes a carrying base **100,** a binder **200,** and a fibrous columnar structure **10** serving as a semiconductor mounting member.

In FIG. **1****,** the fibrous columnar structure **10** includes a plurality of fibrous columnar objects **2.** One end of each of the fibrous columnar objects **2** is fixed onto the binder **200.** The fibrous columnar objects **2** are each aligned in the direction of a length **L**. The fibrous columnar objects **2** are each aligned in a direction substantially perpendicular to the carrying base **100.** The term "direction substantially perpendicular" as used herein means that the angle of the object with respect to the surface of the carrying base **100** is preferably 90°±20°, more preferably 90°±15°, still more preferably 90°±10°, particularly preferably 90°±5°.

The semiconductor mounting member as described above, which is to be used for carrying a semiconductor, the semiconductor mounting member including the fibrous columnar structure including the plurality of fibrous columnar objects also serves as a semiconductor mounting member of the present invention. That is, the semiconductor mounting member of the present invention is a semiconductor mounting member to be used for carrying a semiconductor, including a fibrous columnar structure including a plurality of fibrous columnar objects.

In FIG. **2****,** a schematic sectional view of an example of a semiconductor mounting member according to a preferred embodiment of the present invention is illustrated.

In FIG. **2****,** the semiconductor mounting member consists of the fibrous columnar structure **10,** and the fibrous columnar structure **10** includes the plurality of fibrous columnar objects **2**. The fibrous columnar objects **2** are each aligned in the direction of a length **L.**

In the semiconductor transport member of the present invention, the surface of the fibrous columnar structure on the opposite side to the carrying base has a coefficient of static friction against a glass surface of 2.0 or more. In FIG. **1****,** the "surface of the fibrous columnar structure on the opposite side to the carrying base " refers to a surface **10a** of the fibrous columnar structure **10** on the opposite side to the carrying base **100.**

In the semiconductor mounting member of the present invention, the surface of the fibrous columnar structure has a coefficient of static friction against a glass surface of 2.0 or more. In FIG. **2****,** the "surface of the fibrous columnar structure" refers to the surface **10a** of the fibrous columnar structure **10.**

In the semiconductor transport member of the present invention, the surface of the fibrous columnar structure on the opposite side to the carrying base has a coefficient of static friction against a glass surface of 2.0 or more, preferably 2.4 or more, more preferably 3.0 or more, still more preferably 3.4 or more, even more preferably 3.5 or more, particularly preferably 3.6 or more, most preferably 3.7 or more. In the semiconductor transport member of the present invention, the upper limit value of the coefficient of static friction against a glass surface of the surface of the fibrous columnar structure on the opposite side to the carrying base is preferably 10. When the coefficient of static friction against a glass surface of the surface of the fibrous columnar structure on the opposite side to the carrying base falls within the above-mentioned range in the semiconductor transport member of the present invention, there can be provided a semiconductor transport member that includes a semiconductor mounting member capable of expressing a strong gripping force and unlikely to cause a contaminant to adhere and remain on a semiconductor side. Needless to say, the transport member having a large coefficient of friction against a glass surface is capable of expressing a strong gripping force also for an obj ect to be transported that is formed of a material other than glass (for example, a silicon wafer).

In the semiconductor mounting member of the present invention, the surface of the fibrous columnar structure has a coefficient of static friction against a glass surface of 2.0 or more, preferably 2.4 or more, more preferably 3.0 or more, still more preferably 3.4 or more, even still more preferably 3.5 or more, particularly preferably 3.6 or more, most preferably 3.7 or more. In the semiconductor mounting member of the present invention, the upper limit value of the coefficient of static friction against a glass surface of the surface of the fibrous columnar structure is preferably 10. When the coefficient of static friction against a glass surface of the surface of the fibrous columnar structure falls within the above-mentioned range in the semiconductor mounting member of the present invention, there can be provided a semiconductor transport member that includes a semiconductor mounting member capable of expressing a strong gripping force and unlikely to cause a contaminant to adhere and remain on a semiconductor side.

Any appropriate material may be adopted as a material for each of the fibrous columnar objects. Examples thereof include: metals, such as aluminum and iron; inorganic materials, such as silicon; carbon materials, such as a carbon nanofiber and a carbon nanotube (CNT); and high-modulus resins, such as an engineering plastic and a super engineering plastic. Specific examples of the resin include polystyrene, polyethylene, polypropylene, polyethylene terephthalate, acetyl cellulose, polycarbonate, polyimide, and polyamide. Any appropriate physical property may be adopted as each physical property of the resin, such as the molecular weight thereof, as long as the object of the present invention can be attained.

The diameter of each of the fibrous columnar objects is preferably from 0.3 nm to 2,000 nm, more preferably from 1 nm to 1,000 nm, still more preferably from 2 nm to 500 nm, particularly preferably from 2 nm to 200 nm, most preferably from 2 nm to 100 nm. When the diameter of each of the fibrous columnar objects falls within the above-mentioned range, there can be provided a semiconductor transport member that includes a semiconductor mounting member capable of expressing a stronger gripping force and more unlikely to cause a contaminant to adhere and remain on a semiconductor side.

The fibrous columnar structure is preferably a carbon nanotube aggregate including a plurality of carbon nanotubes. In this case, the fibrous columnar objects are preferably carbon nanotubes.

When the fibrous columnar structure is the carbon nanotube aggregate including the plurality of carbon nanotubes, there can be provided a semiconductor transport member that includes a semiconductor mounting member capable of expressing a stronger gripping force and more unlikely to cause a contaminant to adhere and remain on a semiconductor side.

The carbon nanotube aggregate may preferably adopt two preferred embodiments from the viewpoint that the effect of the present invention is exhibited more effectively.

A preferred embodiment (hereinafter sometimes referred to as "first preferred embodiment") of the carbon nanotube aggregate includes a plurality of carbon nanotubes, in which the carbon nanotubes each have a plurality of walls, the distribution width of the wall number distribution of the carbon nanotubes is 10 walls or more, and the relative frequency of the mode of the wall number distribution is 25% or less. When the carbon nanotube aggregate adopts such structure, there can be provided a semiconductor transport member that includes a semiconductor mounting member capable of expressing a stronger gripping force and more unlikely to cause a contaminant to adhere and remain on a semiconductor side.

In the first preferred embodiment, the distribution width of the wall number distribution of the carbon nanotubes is preferably 10 walls or more, more preferably from 10 walls to 30 walls, still more preferably from 10 walls to 25 walls, particularly preferably from 10 walls to 20 walls. When the distribution width of the wall number distribution of the carbon nanotubes is adjusted to fall within such range, there can be provided a semiconductor transport member that includes a semiconductor mounting member capable of expressing a stronger gripping force and more unlikely to cause a contaminant to adhere and remain on a semiconductor side.

The "distribution width" of the wall number distribution of the carbon nanotubes refers to a difference between the maximum wall number and minimum wall number of the wall numbers of the carbon nanotubes. When the distribution width of the wall number distribution of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

The wall number and the wall number distribution of the carbon nanotubes may be measured with any appropriate device. The wall number and wall number distribution of the carbon nanotubes are preferably measured with a scanning electron microscope (SEM) or a transmission electron microscope (TEM). For example, at least 10, preferably 20 or more carbon nanotubes may be taken out from the carbon nanotube aggregate to evaluate the wall number and the wall number distribution by the measurement with the SEM or the TEM.

In the first preferred embodiment, the maximum wall number of the wall numbers of the carbon nanotubes is preferably from 5 to 30, more preferably from 10 to 30, still more preferably from 15 to 30, particularly preferably from 15 to 25. When the maximum wall number of the wall numbers of the carbon nanotubes is adjusted to fall within such range, there can be provided a semiconductor transport member that includes a semiconductor mounting member capable of expressing a stronger gripping force and more unlikely to cause a contaminant to adhere and remain on a semiconductor side.

In the first preferred embodiment, the minimum wall number of the wall numbers of the carbon nanotubes is preferably from 1 to 10, more preferably from 1 to 5. When the minimum wall number of the wall numbers of the carbon nanotubes is adjusted to fall within such range, there can be provided a semiconductor transport member that includes a semiconductor mounting member capable of expressing a stronger gripping force and more unlikely to cause a contaminant to adhere and remain on a semiconductor side.

In the first preferred embodiment, when the maximum wall number and the minimum wall number of the wall numbers of the carbon nanotubes are adjusted to fall within the above-mentioned ranges, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the first preferred embodiment, the relative frequency of the mode of the wall number distribution of the carbon nanotubes is preferably 25% or less, more preferably from 1% to 25%, still more preferably from 5% to 25%, particularly preferably from 10% to 25%, most preferably from 15% to 25%. When the relative frequency of the mode of the wall number distribution of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the first preferred embodiment, the mode of the wall number distribution of the carbon nanotubes is present at preferably from 2 walls to 10 walls in number, more preferably from 3 walls to 10 walls in number. When the mode of the wall number distribution of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the first preferred embodiment, regarding the shape of each of the carbon nanotubes, the lateral section of the carbon nanotube only needs to have any appropriate shape. The lateral section is of, for example, a substantially circular shape, an oval shape, or an n-gonal shape (n represents an integer of 3 or more) .

In the first preferred embodiment, the length of each of the carbon nanotubes is preferably 50 µm or more, more preferably from 100 µm to 3,000 µm, still more preferably from 300 µm to 1,500 µm, even more preferably from 400 µm to 1,000 µm, particularly preferably from 500 µm to 1,000 µm. When the length of each of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the first preferred embodiment, the diameter of each of the carbon nanotubes is preferably from 0.3 nm to 2,000 nm, more preferably from 1 nm to 1,000 nm, still more preferably from 2 nm to 500 nm. When the diameter of each of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the first preferred embodiment, the specific surface area and density of each of the carbon nanotubes may be set to any appropriate values.

Another preferred embodiment (hereinafter sometimes referred to as "second preferred embodiment") of the carbon nanotube aggregate includes a plurality of carbon nanotubes, in which the carbon nanotubes each have a plurality of walls, the mode of the wall number distribution of the carbon nanotubes is present at 10 or less walls in number, and the relative frequency of the mode is 30% or more. When the carbon nanotube aggregate adopts such structure, there can be provided a semiconductor transport member that includes a semiconductor mounting member capable of expressing a stronger gripping force and more unlikely to cause a contaminant to adhere and remain on a semiconductor side.

In the second preferred embodiment, the distribution width of the wall number distribution of the carbon nanotubes is preferably 9 walls or less, more preferably from 1 wall to 9 walls, still more preferably from 2 walls to 8 walls, particularlypreferably from 3 walls to 8 walls. When the distribution width of the wall number distribution of the carbon nanotubes is adjusted to fall within such range, there can be provided a semiconductor transport member that includes a semiconductor mounting member capable of expressing a stronger gripping force and more unlikely to cause a contaminant to adhere and remain on a semiconductor side.

The "distribution width" of the wall number distribution of the carbon nanotubes refers to a difference between the maximum wall number and minimum wall number of the wall numbers of the carbon nanotubes. When the distribution width of the wall number distribution of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

The wall number and wall number distribution of the carbon nanotubes may be measured with any appropriate device. The wall number and wall number distribution of the carbon nanotubes are preferably measured with a scanning electron microscope (SEM) or a transmission electron microscope (TEM). For example, at least 10, preferably 20 or more carbon nanotubes may be taken out from the carbon nanotube aggregate to evaluate the wall number and the wall number distribution by the measurement with the SEM or the TEM.

In the second preferred embodiment, the maximum wall number of the wall numbers of the carbon nanotubes is preferably from 1 to 20, more preferably from 2 to 15, still more preferably from 3 to 10. When the maximum wall number of the wall numbers of the carbon nanotubes is adjusted to fall within such range, there can be provided a semiconductor transport member that includes a semiconductor mounting member capable of expressing a stronger gripping force and more unlikely to cause a contaminant to adhere and remain on a semiconductor side.

In the second preferred embodiment, the minimum wall number of the wall numbers of the carbon nanotubes is preferably from 1 to 10, more preferably from 1 to 5. When the minimum wall number of the wall numbers of the carbon nanotubes is adjusted to fall within such range, there can be provided a semiconductor transport member that includes a semiconductor mounting member capable of expressing a stronger gripping force and more unlikely to cause a contaminant to adhere and remain on a semiconductor side.

In the second preferred embodiment, when the maximum wall number and minimum wall number of the wall numbers of the carbon nanotubes are adjusted to fall within the above-mentioned ranges, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the second preferred embodiment, the relative frequency of the mode of the wall number distribution of the carbon nanotubes is preferably 30% or more, more preferably from 30% to 100%, still more preferably from 30% to 90%, particularly preferably from 30% to 80%, most preferably from 30% to 70%. When the relative frequency of the mode of the wall number distribution of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the second preferred embodiment, the mode of the wall number distribution of the carbon nanotubes is present at preferably 10 or less walls in number, more preferably from 1 wall to 10 walls in number, still more preferably from 2 walls to 8 walls in number, particularly preferably from 2 walls to 6 walls in number. When the mode of the wall number distribution of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the second preferred embodiment, regarding the shape of each of the carbon nanotubes, the lateral section of the carbon nanotube only needs to have any appropriate shape. The lateral section is of, for example, a substantially circular shape, an oval shape, or an n-gonal shape (n represents an integer of 3 or more).

In the second preferred embodiment, the length of each of the carbon nanotubes is preferably 50 µm or more, more preferably from 500 µm to 3,000 µm, still more preferably from 600 µm to 2,000 µm, even more preferably from 650 µm to 1,000 µm, particularly preferably from 700 µm to 1,000 µm. When the length of each of the carbon nanotubes is adjusted to fall within the above-mentioned range, the carbon nanotubes can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the second preferred embodiment, the diameter of each of the carbon nanotubes is preferably from 0.3 nm to 2, 000 nm, more preferably from 1 nm to 1,000 nm, still more preferably from 2 nm to 500 nm. When the diameter of each of the carbon nanotubes is adjusted to fall within the above-mentioned range, the carbon nanotubes can have both excellent mechanical properties and high specif ic surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

In the second preferred embodiment, the specific surface area and density of each of the carbon nanotubes may be set to any appropriate values.

Any appropriate method may be adopted as a method of producing the carbon nanotube aggregate.

The method of producing the carbon nanotube aggregate is, for example, a method of producing a carbon nanotube aggregate aligned substantially perpendicularly from a smooth substrate by chemical vapor deposition (CVD) involving forming a catalyst layer on the substrate and filling a carbon source in a state in which a catalyst is activated with heat, plasma, or the like to grow the carbon nanotubes. In this case, for example, the removal of the substrate provides a carbon nanotube aggregate aligned in a lengthwise direction.

Any appropriate substrate maybe adopted as the substrate that may be used in the method of producing the carbon nanotube aggregate. The substrate is, for example, a material having smoothness and high-temperature heat resistance enough to resist the production of the carbon nanotubes. Examples of such material include quartz glass, silicon (such as a silicon wafer), and a metal plate made of, for example, aluminum.

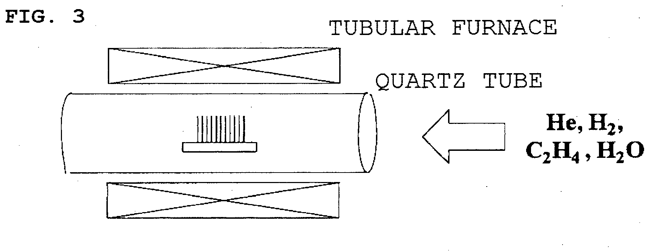

Any appropriate apparatus may be adopted as an apparatus for producing the carbon nanotube aggregate. The apparatus is, for example, a thermal CVD apparatus of a hot wall type formed by surrounding a cylindrical reaction vessel with a resistance heating electric tubular furnace as illustrated in FIG. **3****.** In this case, for example, a heat-resistant quartz tube is preferably used as the reaction vessel.

Any appropriate catalyst may be used as the catalyst (material for the catalyst layer) that may be used in the production of the carbon nanotube aggregate. Examples of the catalyst include metal catalysts, such as iron, cobalt, nickel, gold, platinum, silver, and copper.

In the production of the carbon nanotube aggregate, an alumina/hydrophilic film may be formed between the substrate and the catalyst layer as required.

Any appropriate method may be adopted as a method of producing the alumina/hydrophilic film. For example, the film may be obtained by producing a SiO₂ film on the substrate, depositing Al from the vapor, and increasing the temperature of Al to 450°C after the deposition to oxidize Al. According to such production method, Al₂O₃ interacts with the hydrophilic SiO₂ film, and hence an Al₂O₃ surface different from that obtained by directly depositing Al₂O₃ from the vapor in particle diameter is formed. When Al is deposited from the vapor, and then its temperature is increased to 450°C so that Al may be oxidized without the production of any hydrophilic film on the substrate, it may be difficult to form the Al₂O₃ surface having a different particle diameter. In addition, when the hydrophilic film is produced on the substrate and Al₂O₃ is directly deposited from the vapor, it may also be difficult to form the Al₂O₃ surface having a different particle diameter.

The thickness of the catalyst layer that may be used in the production of the carbon nanotube aggregate is preferably from 0.01 nm to 20 nm, more preferably from 0.1 nm to 10 nm in order to form fine particles. When the thickness of the catalyst layer that may be used in the production of the carbon nanotube aggregate is adjusted to fall within the above-mentioned range, the carbon nanotubes to be formed can have both excellent mechanical properties and high specific surface area, and moreover, the carbon nanotubes can provide a carbon nanotube aggregate exhibiting an excellent pressure-sensitive adhesive property. Therefore, the semiconductor transport member including the carbon nanotube aggregate as described above can serve as a semiconductor transport member that includes a semiconductor mounting member capable of expressing a stronger gripping force and more unlikely to cause a contaminant to adhere and remain on a semiconductor side.

Any appropriate method may be adopted as a method of forming the catalyst layer. Examples of the method include a method involving depositing a metal catalyst from the vapor, for example, with an electron beam (EB) or by sputtering and a method involving applying a suspension of metal catalyst fine particles onto the substrate.

Any appropriate carbon source may be used as the carbon source that may be used in the production of the carbon nanotube aggregate. Examples thereof include: hydrocarbons, such as methane, ethylene, acetylene, and benzene; and alcohols, such as methanol and ethanol.

Any appropriate temperature may be adopted as a production temperature in the production of the carbon nanotube aggregate. For example, the temperature is preferably from 400°C to 1,000°C, more preferably from 500°C to 900°C, still more preferably from 600°C to 800°C in order that catalyst particles allowing sufficient expression of the effect of the present invention may be formed.

### Examples

Now; the present invention is described by way of Examples. However, the present invention is not limited thereto. Various evaluations and measurements were performed by the following methods.

### <Measurement of Length L of Fibrous Columnar Object>

The length **L** of a fibrous columnar object was measured with a scanning electron microscope (SEM).

### <Evaluation of Wall Numbers and Wall Number Distribution of Carbon Nanotubes in Carbon Nanotube Aggregate>

The wall numbers and wall number distribution of carbon nanotubes in a carbon nanotube aggregate were measured with a scanning electron microscope (SEM) and/or a transmission electron microscope (TEM). At least 10 or more, preferably 20 or more carbon nanotubes in an obtained carbon nanotube aggregate were observed with the SEM and/or the TEM to investigate the wall number of each carbon nanotube, and the wall number distribution was created.

### <Measurement of Coefficient of Static Friction against Glass Surface>

Measurement was performed in accordance with JIS K7125.

A carbon nanotube columnar structure (80 mmx200 mm) on a silicon wafer was pressed against a polypropylene base material that had been heated to 200°C (30 µm thick) to transfer the carbon nanotube columnar structure from the silicon wafer onto the polypropylene base material. Thus, a "carbon nanotube structure/polypropylene film" test piece having a tape shape was prepared. The carbon nanotube side of the test piece having a tape shape was placed on a slide glass (manufactured by Matsunami Glass Ind. , Ltd.), a sliding piece (bottom surface: felt, 63 mmx63 mm) was placed thereon, and a weight (weight having such a weight that the total mass of the sliding piece became 200 g) was placed on the sliding piece. Under this state, the test piece was pulled at a test speed of 100 mm/min, and its coefficient of static friction was calculated from the maximum load at the time when the test piece started to move.

### <Evaluation of Surface Contamination>

A carbon nanotube columnar structure was pressed against and attached onto a silicon wafer (manufactured by Silicon Technology Corporation). After that, the carbon nanotube columnar structure was peeled from the silicon wafer (manufactured by Silicon Technology Corporation) by 180° peeling. The attached surface side of the silicon wafer was subjected to morphological observation with a SEM to confirm the presence or absence of foreign matter adhering to the surface.

### [Example 1]

An Al thin film (thickness: 10 nm) was formed on a silicon wafer (manufactured by Silicon Technology Co., Ltd.) serving as a substrate with a sputtering apparatus (RFS-200 manufactured by ULVAC, Inc.). An Fe thin film (thickness: 1 nm) was further deposited from the vapor onto the Al thin film with the sputtering apparatus (RFS-200 manufactured by ULVAC, Inc.).

After that, the substrate was placed in a quartz tube of 30 mmϕ, and a helium/hydrogen (90/50 sccm) mixed gas having its moisture content kept at 600 ppm was flowed into the quartz tube for 30 minutes to replace the inside of the tube. After that, the temperature in the tube was increased with an electric tubular furnace to 765°C and stabilized at 765°C. While the temperature was kept at 765°C, the inside of the tube was filled with a helium/hydrogen/ethylene (80/50/5 sccm, moisture content: 600 ppm) mixed gas, and the resultant was left to stand for 5 minutes to grow carbon nanotubes on the substrate. Thus, a carbon nanotube aggregate (1) in which the carbon nanotubes were aligned in their lengthwise directions was obtained.

The length of each of the carbon nanotubes included in the carbon nanotube aggregate (1) was 100 µm.

In the wall number distribution of the carbon nanotubes included in the carbon nanotube aggregate (1), the mode was present at 2 walls, and its relative frequency was 75%.

The carbon nanotube aggregate (1) formed on the substrate was peeled from the substrate to provide a semiconductor mounting member (1).

The end surface of the resultant semiconductor mounting member (1) on the side peeled from the substrate was buried in an ultra-heat-resistant carbon paste (manufactured by EM Japan), and the resultant was cured (room temperature×2 hours, 90°C×2 hours, 260°C×2 hours, 450°C×3 hours) and fixed onto a transport table. Thus, a semiconductor transport member (1) was obtained.

The evaluation results are shown in Table 1.

### [Example 2]

A carbon nanotube aggregate (2) in which carbon nanotubes were aligned in their lengthwise directions was obtained in the same manner as in Example 1 except that in Example 1, the period of time for standing was changed to 25 minutes.

The carbon nanotubes included in the carbon nanotube aggregate (2) each had a length of 500 µm.

In the wall number distribution of the carbon nanotubes included in the carbon nanotube aggregate (2), the mode was present at 2 walls, and its relative frequency was 75%.

A semiconductor mounting member (2) and a semiconductor transport member (2) were obtained in same manner as in Example 1.

The evaluation results are shown in Table 1.

### [Example 3]

A carbon nanotube aggregate (3) in which carbon nanotubes were aligned in their lengthwise directions was obtained in the same manner as in Example 1 except that in Example 1, the thickness of the Fe thin film was changed to 2 nm and the period of time for standing of the reaction was changed to 35 minutes.

The carbon nanotubes included in the carbon nanotube aggregate (3) each had a length of 700 µm.

In the wall number distribution of the carbon nanotubes included in the carbon nanotube aggregate (3), the mode was present at 3 walls, and its relative frequency was 72%.

A semiconductor mounting member (3) and a semiconductor transport member (3) were obtained in same manner as in Example 1.

The evaluation results are shown in Table 1.

### [Example 4]

An Al thin film (thickness: 10 nm) was formed on a silicon substrate (manufactured by KST, wafer with a thermally oxidized film, thickness: 1,000 µm) with a vacuum deposition apparatus (manufactured by JEOL, JEE-4X Vacuum Evaporator), and was then subjected to oxidation treatment at 450°C for 1 hour. Thus, an Al₂O₃ film was formed on the silicon substrate. On the Al₂O₃ film, an Fe thin film (thickness: 2 nm) was further deposited with a sputtering apparatus (manufactured by ULVAC, RFS-200) to form a catalyst layer.

Next, the resultant silicon substrate with a catalyst layer was cut and placed in a quartz tube of 30 mmϕ, and a helium/hydrogen (120/80 sccm) mixed gas having its moisture content kept at 350 ppm was flowed into the quartz tube for 30 minutes to replace the inside of the tube. After that, the temperature in the tube was gradually increased with an electric tubular furnace to 765°C in 35 minutes and stabilized at 765°C. While the temperature was kept at 765°C, the inside of the tube was filled with a helium/hydrogen/ethylene (105/80/15 sccm, moisture content: 350 ppm) mixed gas, and the resultant was left to stand for 5 minutes to grow carbon nanotubes on the substrate. Thus, a carbon nanotube aggregate (4) in which the carbon nanotubes were aligned in their lengthwise directions was obtained.

The carbon nanotubes included in the carbon nanotube aggregate (4) each had a length of 100 µm.

In the wall number distribution of the carbon nanotubes included in the carbon nanotube aggregate (4), the distribution width of the wall number distribution was 17 walls (4 walls to 20 walls), the modes were present at 4 walls and 8 walls, and their relative frequencies were 20% and 20%, respectively.

A semiconductor mounting member (4) and a semiconductor transport member (4) were obtained in same manner as in Example 1.

The evaluation results are shown in Table 1.

### [Example 5]

A carbon nanotube aggregate (5) in which carbon nanotubes were aligned in their lengthwise directions was obtained in the same manner as in Example 4 except that in Example 4, the period of time for standing was changed to 15 minutes.

The carbon nanotubes included in the carbon nanotube aggregate (5) each had a length of 300 µm.

In the wall number distribution of the carbon nanotubes included in the carbon nanotube aggregate (5), the distribution width of the wall number distribution was 17 walls (4 walls to 20 walls), the modes were present at 4 walls and 8 walls, and their relative frequencies were 20% and 20%, respectively.

A semiconductor mounting member (5) and a semiconductor transport member (5) were obtained in same manner as in Example 4.

The evaluation results are shown in Table 1.

### [Example 6]

A carbon nanotube aggregate (6) in which carbon nanotubes were aligned in their lengthwise directions was obtained in the same manner as in Example 4 except that in Example 4, the period of time for standing was changed to 25 minutes.

The carbon nanotubes included in the carbon nanotube aggregate (6) each had a length of 500 µm.

In the wall number distribution of the carbon nanotubes included in the carbon nanotube aggregate (6), the distribution width of the wall number distribution was 17 walls (4 walls to 20 walls), the modes were present at 4 walls and 8 walls, and their relative frequencies were 20% and 20%, respectively.

A semiconductor mounting member (6) and a semiconductor transport member (6) were obtained in same manner as in Example 4.

The evaluation results are shown in Table 1.

### [Comparative Example 1]

Polydimethylsiloxane (PDMS) (trade name: "Sylgard 184", manufactured by Dow Corning) was used as a semiconductor mounting member (C1).

The resultant semiconductor mounting member (C1) was formed so as to have a thickness of 500 µm and cured to provide a semiconductor transport member (C1).

The evaluation results are shown in Table 1.

**Table 1**

| | Type | Length (µm) | Coefficient of static friction | Surface contamination |
|---|---|---|---|---|
| Example 1 | DW-75 | 100 | 2.45 | Absent |
| Example 2 | DW-75 | 500 | 3.48 | Absent |
| Example 3 | TW-72 | 700 | 3.72 | Absent |
| Example 4 | Broad | 100 | 2.90 | Absent |
| Example 5 | Broad | 300 | 3.55 | Absent |
| Example 6 | Broad | 500 | 3.81 | Absent |
| Comparative Example 1 | Silicon rubber | 500 | 0.03 | Present |

### Industrial Applicability

The semiconductor transport member and the semiconductor mounting member of the present invention can be applied to, for example, a semiconductor production process.

### Reference Signs List

- **1000**: semiconductor transport member
- **100**: carrying base
- **200**: binder
- **10**: fibrous columnar structure
- **10a**: surface of fibrous columnar structure
- **2**: fibrous columnar object

## Claims

1. A semiconductor transport member, comprising:
a carrying base; and
a semiconductor mounting member,
wherein:
the semiconductor mounting member includes a fibrous columnar structure;
the fibrous columnar structure comprises a fibrous columnar structure including a plurality of fibrous columnar objects;
the fibrous columnar objects are each aligned in a direction substantially perpendicular to the carrying base; and
a surface of the fibrous columnar structure on an opposite side to the carrying base has a coefficient of static friction against a glass surface of 2.0 or more.

2. The semiconductor transport member according to claim 1, further comprising a binder between the carrying base and the semiconductor mounting member.

3. The semiconductor transport member according to claim 1 or 2, wherein the fibrous columnar structure comprises a carbon nanotube aggregate including a plurality of carbon nanotubes.

4. The semiconductor transport member according to claim 3, wherein the carbon nanotubes each have a plurality of walls, and a relative frequency of a mode of the wall number distribution is 25% or less.

5. The semiconductor transport member according to claim 4, wherein the carbon nanotubes each have a length of 300 µm or more.

6. The semiconductor transport member according to claim 3, wherein the carbon nanotubes each have a plurality of walls, a mode of a wall number distribution of the carbon nanotubes is present at 10 or less walls in number, and a relative frequency of the mode is 30% or more.

7. The semiconductor transport member according to claim 6, wherein the carbon nanotubes each have a length of 500 µm or more.

8. A semiconductor mounting member to be used for carrying a semiconductor, comprising a fibrous columnar structure including a plurality of fibrous columnar objects,
wherein a surface of the fibrous columnar structure has a coefficient of static friction against a glass surface of 2.0 or more.

9. The semiconductor mounting member according to claim 8, wherein the fibrous columnar structure comprises a carbon nanotube aggregate including a plurality of carbon nanotubes.

10. The semiconductor mounting member according to claim 9, wherein the carbon nanotubes each have a plurality of walls, a distribution width of a wall number distribution of the carbon nanotubes is 10 walls or more, and a relative frequency of a mode of the wall number distribution is 25% or less.

11. The semiconductor mounting member according to claim 10, wherein the carbon nanotubes each have a length of 300 µm or more.

12. The semiconductor mounting member according to claim 9, wherein the carbon nanotubes each have a plurality of walls, a mode of a wall number distribution of the carbon nanotubes is present at 10 or less walls in number, and a relative frequency of the mode is 30% or more.

13. The semiconductor mounting member according to claim 12, wherein the carbon nanotubes each have a length of 500 µm or more.
